# EUROPÄISCHE PATENTSCHRIFT

(11) **EP 1 738 404 B1**
(45) Veröffentlichungstag und Bekanntmachung des Hinweises auf die Patenterteilung: **04.04.2018**
(21) Anmeldenummer: 05748572.4
(22) Anmeldetag: 21.04.2005
(51) Int. Cl.: H01L 21/3213

(54) **VERFAHREN ZUR STRUKTURIERUNG VON ZUMINDEST EINER SCHICHT SOWIE ELEKTRISCHES BAUELEMENT MIT STRUKTUREN AUS DER SCHICHT**
METHOD FOR STRUCTURING AT LEAST ONE LAYER AND ELECTRIC COMPONENT WITH STRUCTURES FROM SAID LAYER
PROCEDE POUR STRUCTURER AU MOINS UNE COUCHE ET COMPOSANT ELECTRIQUE A STRUCTURES ISSUES DE LADITE COUCHE

(30) Priorität: 22.04.2004 DE 102004019588
(43) Veröffentlichungstag der Anmeldung: 03.01.2007
(73) Patentinhaber: OSRAM Opto Semiconductors GmbH, 93055 Regensburg (DE)
(72) Erfinder: HACKENBERGER, Maja, 93152 Nittendorf (DE); VÖLKL, Johannes, 91056 Erlangen (DE); ZEISEL, Roland, 93105 Tegernheim (DE)
(74) Vertreter: Epping - Hermann - Fischer
(86) Internationale Anmeldenummer: PCT/DE2005/000736
(87) Internationale Veröffentlichungsnummer: WO 2005/103818

(56) Entgegenhaltungen:
- DE-A1- 10 105 163
- US-A- 5 225 372
- US-A- 5 420 078
- US-A1- 2002 175 381

## Beschreibung

Verfahren zur Strukturierung von zumindest einer Schicht sowie elektrisches Bauelement mit Strukturen aus der Schicht Bei der Herstellung von Halbleiterstrukturen und elektrischen Bauelementen ist es häufig nötig, wenigstens zwei Strukturen aus zumindest einer Schicht zu strukturieren. Dabei werden häufig separat für jede zu erzeugende Struktur ein Photoresist auf der Schicht aufgebracht, belichtet, entwickelt und anschließend die Struktur des Photoresists in die Schicht übertragen. Derartige Verfahren sind zeitaufwendig und kompliziert, da sie die separate Aufbringung von zwei Fotolackschichten sowie die separate Strukturierung der ersten und zweiten Struktur aus der zumindest einen Schicht erfordern. Die Aufgabe der vorliegenden Erfindung besteht darin, ein Verfahren anzugeben, das bezüglich der oben genannten Nachteile verbessert ist.

Diese Aufgabe wird erfindungsgemäß durch ein Verfahren nach Anspruch 1 gelöst. Vorteilhafte Ausgestaltungen des Verfahrens sowie ein Bauelement mit mittels dieses Verfahrens hergestellten Strukturen sind Gegenstand weiterer Ansprüche. Beschrieben wird ein Verfahren zur Erzeugung einer strukturierten Schicht mit den Verfahrensschritten:
A) auf einem Substrat wird zumindest eine Schicht angeordnet,
B) auf der zumindest einen Schicht wird eine Maskenstruktur mit einer ersten und zweiten Struktur erzeugt,
C) die zumindest eine Schicht wird durch ein isotropes Verfahren strukturiert,
D) anschließend wird die zumindest eine Schicht durch ein anisotropes Verfahren strukturiert.

Im Gegensatz zu den oben genannten herkömmlichen Verfahren wird beim beschriebenen Verfahren nur eine Maskenstruktur benötigt, da in den Verfahrensschritten C) und D) die Schicht mittels der ersten Struktur und der zweiten Struktur der Maskenstruktur durch isotrope und anschließend anisotrope Verfahren strukturiert wird. Bei isotropen Strukturierungsverfahren ist die Strukturierungsrate richtungsunabhängig, z.B. beim isotropen Ätzen mit naßchemischen Ätzmitteln. Aufgrund der isotropen Strukturierung werden dabei im Verfahrensschritt C) unter der ersten Struktur große Bereiche der zumindest einen Schicht entfernt, so dass darunter liegende Bereiche dieser Schicht dann der Strukturierung im Verfahrensschritt D) zugänglich sind. Beim anisotropen Verfahren ist die Strukturierungsrate richtungsabhängig. Als isotrope Strukturierungsverfahren im Verfahrensschritt C) kommen beispielsweise nasschemische Ätzverfahren und als anisotrope Strukturierungsverfahren im Verfahrensschritt D) beispielsweise Sputterverfahren in Frage. Weitere Beispiele für isotrop wirkende Ätzmittel sind naßchemische Ätzmedien wie HF- und HCl-Lösungen und für anisotrope Ätzmittel z. B. Argon- oder Chlor-Plasmen. Somit ist es möglich, aufgrund der Kombination von isotropen Strukturierungsverfahren im Verfahrensschritt C) und anisotropen Strukturierungsverfahren im Verfahrensschritt D) zwei Strukturen in zumindest einer Schicht mit nur einer Maskenstruktur zu erzeugen.

In einer vorteilhaften Ausführungsform werden im Verfahrensschritt A) eine erste Schicht und darüber zumindest eine zweite Schicht erzeugt, wobei dann in C) die zweite Schicht und in D) die erste Schicht strukturiert werden. Aufgrund der isotropen Strukturierung im Verfahrensschritt C) können dabei unterhalb der zweiten Struktur der Maskenstruktur größere Teile der zweiten Schicht entfernt und somit größere Bereiche der ersten Schicht freigelegt werden, die dann einer Strukturierung im Verfahrensschritt D) zugänglich sind. Anschließend wird im Verfahrensschritt D) die zweite Struktur der Maskenstruktur möglichst genau mittels eines anisotropen Strukturierungsverfahrens in die erste Schicht übertragen.

Günstigerweise wird im Verfahrensschritt C) die erste Struktur der Maskenstruktur und im Verfahrensschritt D) die zweite Struktur der Maskenstruktur in die zumindest eine Schicht übertragen.

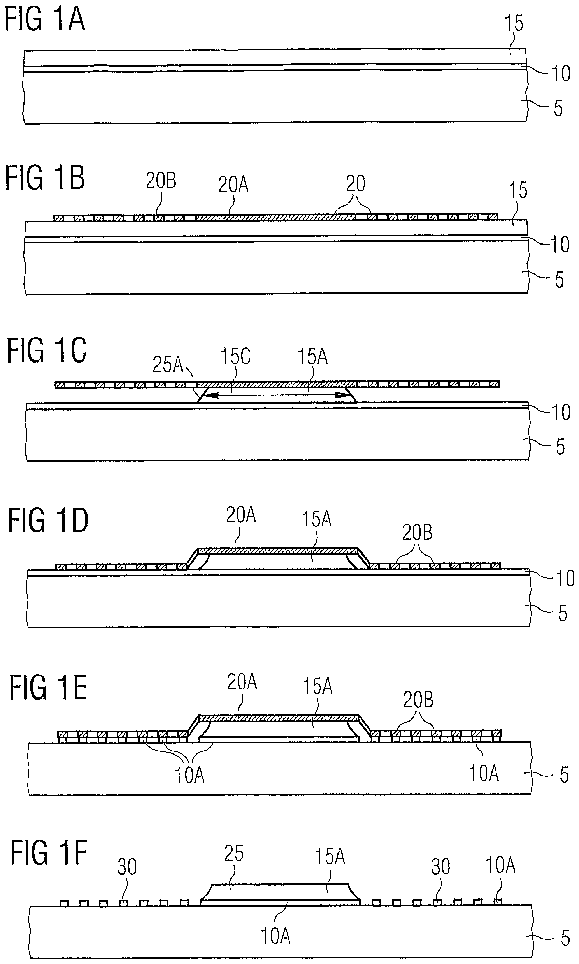

Die erste Struktur der Maskenstruktur kann eine Grobstruktur sein, die im Vergleich zur zweiten Struktur, einer Feinstruktur relativ große Ausdehnungen aufweist. Die kleinste Ausdehnung der Grobstruktur ist dabei vorzugsweise doppelt so groß, wie die kleinste Ausdehnung der Feinstruktur. Durch das isotrope Strukturieren im Verfahrensschritt C) kann es dabei zu einer Unterhöhlung der zweiten Feinstruktur in der Maskenstruktur kommen, so dass dort nur im wesentlichen die Grobstruktur in die zumindest eine Schicht überführt wird (siehe z. B. Fig. 1C). Somit kann das isotrope Strukturieren in C) über die Feinstruktur "hinwegmitteln", so dass diese vollständiges unterätzt und daher nicht übertragen wird. Erst im anisotropen Strukturierungsschritt D) wird dann die zweite Feinstruktur in die zumindest eine Schicht übertragen. Werden eine erste und eine zweite Schicht auf das Substrat aufgebracht, so wird vorteilhafterweise die Grobstruktur in die zweite Schicht und die Feinstruktur in die erste Schicht übertragen. Die Grobstruktur kann dabei z. B. eine Form für ein Bondpad mit einer bestimmten geometrischen Form (z.B. rund, dreieckig, vieleckig) sein und die Feinstruktur können z. B. linienförmige Strukturen für Kontaktlinien oder feine Leiterbahnen sein.

Wenn anstelle der ersten und zweiten Schicht nur eine Schicht auf dem Substrat vorhanden ist, können im Verfahrensschritt C) Bereiche dieser Schicht, die benachbart zu der groben Maskenstruktur sind aufgrund des isotropen Strukturierungsverfahrens entfernt werden und nur die Grobstruktur der Maskenstruktur in diese Schicht überführt werden. In Verfahrensschritt D) kann dann die Feinstruktur in von der groben Maskenstruktur weiter entfernte Bereiche dieser Schicht übertragen werden.

Weiterhin ist es vorteilhaft im Falle des Vorhandenseins von der ersten und zweiten Schicht auf dem Substrat, wenn im Verfahrensschritt C) ein für die zweite Schicht selektives Ätzmittel und gegebenenfalls auch im Verfahrensschritt D) ein für die erste Schicht selektives Ätzmittel verwendet werden. Dadurch kann gewährleistet werden, dass in den Verfahrensschritten C) und D) jeweils nur die gewünschten Schichten strukturiert werden. Die Auswahl der Ätzmittel ist dabei von der Beschaffenheit der ersten und zweiten Schicht abhängig. Wenn die erste Schicht eine Metallschicht und die zweite Schicht eine Dielektrikumsschicht, z.B. SiO₂ ist, können z.B. in C) HF und in D) Sputter-Verfahren eingesetzt werden.

Bei der ersten und zweiten zu strukturierenden Schicht kann es sich beispielsweise um Metallschichten handeln. Wenn die beiden strukturierten Schichten zur Kontaktierung eines elektrischen Bauelements eingesetzt werden sollen, ist es besonders vorteilhaft, wenn die erste Schicht eine Platinschicht und als zweite Schicht eine Goldschicht auf dem Substrat erzeugt werden. Beide metallischen Schichten sind besonders gut elektrisch leitfähig, wobei auf der Goldschicht noch besonders einfach, beispielsweise mittels Bond-Verfahren, z. B. Ultraschall-Bonden, ein Draht zur elektrischen Kontaktierung angebracht werden kann.

Im Verfahrensschritt B) des Verfahrens wird vorteilhafterweise eine Fotolackschicht erzeugt und mittels Fotolithographie (Strukturierung durch Belichten und anschließendes Entwickeln) zur Maskenstruktur strukturiert. Strukturierte Fotolackschichten sind besonders als Maskenstrukturen beim Verfahren geeignet. Es ist allerdings auch möglich, nicht fotostrukturierbare Maskenstrukturen im Verfahrensschritt B) zu erzeugen. Beispielsweise wäre es möglich, eine Polymerschicht auf der zweiten Schicht zu erzeugen, beispielsweise eine Polyimidschicht und diese anschließend mittels strukturiertem Ätzen durch eine Maske hindurch zur Maskenstruktur zu strukturieren. Bei einem vorteilhaften Beispiel des Verfahrens wird in einem nach C) stattfindenden Verfahrensschritt C1) die Maskenstruktur in Bereichen, in denen die zweite Schicht unterhalb der Maskenstruktur entfernt wurde, auf die erste Schicht abgesenkt. Ein derartiger zusätzlicher Verfahrensschritt ist beispielsweise in Figur 1D gezeigt. Es ist möglich, im Verfahrensschritt C) aufgrund des isotropen Strukturierungsverfahrens große Bereiche der Maskenstruktur durch eine Entfernung der zweiten Schicht zu unterhöhlen (siehe beispielsweise Figur 1C). In diesem Fall ist es dann besonders vorteilhaft, im Verfahrensschritt C1) die Maskenstruktur auf die erste Schicht abzusenken, um dann zu gewährleisten, dass die Struktur der Maskenstruktur besonders genau im Verfahrensschritt D) auf die erste Schicht mittels des anisotropen Strukturierungsverfahrens übertragen werden kann. Ein Absenken der Maskenstruktur auf die erste Schicht kann beispielsweise dadurch erreicht werden, dass die Maskenstruktur getrocknet wird oder dass zur Trocknung der Maskenstruktur die gesamte Anordnung aus dem Substrat mit der ersten und zweiten Schicht und der Maskenstruktur in eine Schleuder eingebracht wird und anschließend geschleudert wird, wobei die Maskenstruktur trocknet und gleichzeitig auf die erste Schicht abgesenkt wird.

Ein Trocknen der Maskenstruktur ist vor allem dann zweckmäßig, wenn die im Verfahrensschritt C) eingesetzten Strukturierungsmittel, z. B. Ätzchemikalien mittels eines Reinigungsmittels, z.B. Wasser entfernt werden und anschließend das restliche Wasser entfernt werden soll.

Günstigerweise wird im Verfahrensschritt C) die zweite Schicht bis auf einen oder mehrere Bereiche unterhalb der Maskenstruktur komplett entfernt. Somit liegen sehr große Bereiche der ersten Schicht frei und sind somit einer Strukturierung im Verfahrensschritt B) besonders einfach zugänglich. Weiterhin kann in einem an den Verfahrensschritt D) anschließenden Verfahrensschritt E) die Maskenstruktur entfernt werden. Die Maskenstruktur wird in diesem Fall als temporär vorhandene Struktur nur zur Strukturierung der ersten und zweiten Schicht bzw. der einen Schicht benötigt und kann danach wieder entfernt werden.

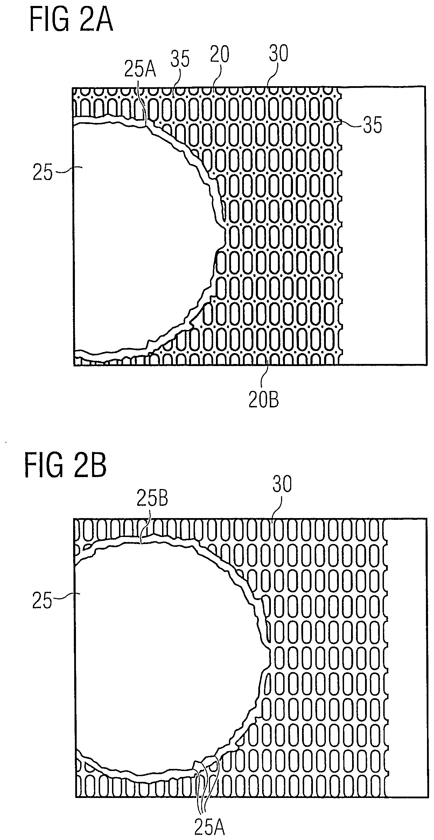

Vorteilhafterweise wird das Verfahren so modifiziert, dass es ein Verfahren zur Herstellung eines elektrischen Bauelements, insbesondere der elektrischen Anschlüsse des elektrischen Bauelements zum Gegenstand hat. Dabei wird im Verfahrensschritt A) das Substrat mit zusätzlichen funktionellen Schichten bereitgestellt und im Verfahrensschritt B) eine Maskenstruktur mit einem geometrisch geformten flächigen Bereich als erste Struktur und davon ausgehenden linienförmigen Strukturen als zweite Struktur erzeugt. Eine derartige Maske ist beispielsweise in der Figur 1 gezeigt. Anschließend wird im Verfahrensschritt C) die zweite Schicht zu einem unterhalb des geometrisch geformten Bereichs der Maskenstruktur angeordneten Bereich strukturiert, wobei ein Bondpad gebildet wird (siehe beispielsweise Figur 1C und Figur 2). Anschließend werden dann im Verfahrensschritt D) die linienförmigen Strukturen der Maskenstruktur in die erste Schicht übertragen, wobei Kontaktlinien gebildet werden (siehe beispielsweise Figur 1E). Das Bondpad weist dabei eine im wesentlichen der geometrischen Form des Bereichs der Maskenstruktur entsprechende Form auf. Das bedeutet, dass im Vergleich zu der geometrischen Form des Bereichs der Maskenstruktur das Bondbad zusätzliche Einbuchtungen und auch einen sich zum Substrat hin verbreitenden Querschnitt aufweist(siehe beispielsweise Figuren 1C, 2 und 3). Die Einbuchtungen und der sich zum Substrat hin verbreiternde Querschnitt sind dabei auf das isotrope Strukturierungsverfahren in C) zurückzuführen, das zu einer Unterhöhlung der Maskenstruktur führt.

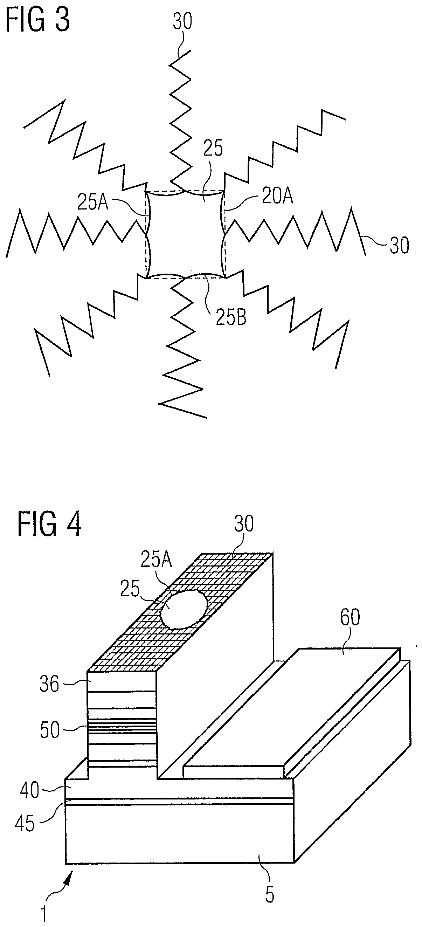

Ein dieser Variante des Verfahrens ähnliches Verfahren mit einem zusätzlichen Verfahrensschritt C1) ist in den Figuren 1A bis 1F schematisch im Querschnitt dargestellt. Der geometrisch geformte Bereich der Maskenstruktur, der einen durchgehenden Schichtbereich in der Maskenstruktur bildet, dient dabei zur Strukturierung des Bondpads aus der zweiten Schicht. Die geometrische Form des Bereichs kann dabei beliebig gewählt werden. Möglich sind beispielsweise Vierecke, wie in Figur 3 gezeigt, ovale, runde oder dreieckige oder beliebige Vieleckformen. Weiterhin ist es möglich, dass die geometrische Form des Bereichs der Maskenstruktur auch beliebige irreguläre Formen annehmen kann. Bei der isotropen Strukturierung im Verfahrensschritt C) wird dabei die geometrische Form des Bereichs der Maskenstruktur in die zweite Schicht abgebildet, wobei es aufgrund des isotropen Strukturierungsverfahrens zu einer Unterhöhlung der Maskenstruktur kommt, so dass die geometrische Form des Bereichs der Maskenstruktur nur grob in die zweite Schicht übertragen wird (siehe beispielsweise Figuren 1C und 3). In Abhängigkeit vom verwendeten isotropen Ätzmedium, der Beschaffenheit der zweiten Schicht und der Dauer des Ätzvorgangs im Verfahrensschritt C) resultieren dabei Einbuchtungen in der Form des Bondpads. Somit wird eine z. B. runde Form des Bereichs der Maskenstruktur so in die zweite Schicht übertragen, dass das Bondpad eine runde Form mit zusätzlichen Einbuchtungen aufweist (siehe Figur 2). Weiterhin weist das Bondpad aus der zweiten strukturierten Schicht aufgrund des isotropen Strukturierungsverfahrens einen sich zum Substrat hin verbreiternden Querschnitt auf, wie ebenfalls in Figur 1C gezeigt.

Somit lassen sich mittels einer Variante des Verfahrens besonders einfach Kontaktlinien und Bondpads für elektrische Bauelemente herstellen, wobei die Herstellung durch das Verfahren anhand der Geometrie und der Form des Bondpads des fertigen Bauelements erkannt werden können (Bondpad weist geometrische Form des Bereichs der Maskenstruktur mit zusätzlichen Einbuchtungen und zusätzlich einen sich zum Substrat hin verbreiternden Querschnitt auf). Die mittels dieser Variante des Verfahrens hergestellten Kontaktlinien sind im elektrischen Kontakt mit dem Bondpad und sorgen dafür, dass der elektrische Strom der am Bondpad beispielsweise mittels eines gebondeten Drahts angelegt werden kann, gleichmäßig über das komplette Substrat bzw. die darauf aufgebrachten funktionellen Schichten einwirkt. Die Kontaktlinien "verteilen" somit den am Bondpad anliegenden Strom möglichst gleichmäßig über die funktionellen Schichten des Bauelements. Die Kontaktlinien können dabei verschiedenste beliebige Formen annehmen. Beispielweise können sie gitterförmig ausgeformt sein (siehe beispielsweise Figuren 2 und 4). Weiterhin können die Kontaktlinien ebenfalls strahlenförmig und gezackt ausgeformt sein wie in Figur 3 gezeigt.

Weiterhin ist es möglich, Varianten des Verfahrens zur Herstellung von aktiven Elementen, z. B. elektrisch leitenden Strukturen von elektrischen Bauelementen und deren Bondpads zu verwenden. Beispielsweise können die elektrisch leitenden Mikrostrukturen (z.B. interdigitale Fingerelektroden) von Oberflächenwellen-Bauelementen und Bondpads, die im elektrischen Kontakt mit diesen stehen besonders einfach mittels Abwandlungen des Verfahrens hergestellt werden. Die elektrisch leitenden Mikrostrukturen von Oberflächenwellen-Bauelementen umfassen z. B. Aluminium, während die mit diesen in Kontakt stehenden Bondpads Gold umfassen können.

Gegenstand der Erfindung ist weiterhin ein elektrisches Bauelement laut Anspruch 15, umfassend ein Substrat mit einer darauf angeordneten ersten und zweiten Struktur, wobei die erste Struktur mittels eines isotropen und die zweite Struktur mittels eines anisotropen Strukturierungsverfahrens aus zumindest einer Schicht strukturiert ist. Die erste Struktur zeigt dabei aufgrund des isotropen Strukturierungsverfahrens einen sich zum Substrat hin verbreiternden Querschnitt sowie eine irreguläre geometrische Form die im wesentlichen der Form einer zur Erzeugung dieser ersten Struktur eingesetzten Maskenstruktur entspricht und zusätzliche Einbuchtungen aufgrund der isotropen Strukturierung aufweist. Die erste Struktur kann z.B. ein Bondpad und die zweite Struktur Kontaktlinien, z. B. Leiterbahnen oder ein Kontaktgitter sein.

Bei herkömmlichen Bauelementen weisen die Bondpads in der Regel eine bestimmte geometrische Form, beispielsweise kreisrunde Formen oder Vierecke, auf, wobei keine zusätzlichen Einbuchtungen und auch kein sich zum Substrat hin verbreitender Querschnitt vorhanden sind. Dies ist darauf zurückzuführen, dass bei herkömmlichen Herstellungsverfahren für elektrische Kontakte anisotrope Strukturierungsverfahren eingesetzt werden, die die Strukturen des Photoresists senkrecht in die zu strukturierenden Schichten übertragen.

Ein hier beschriebenes Bauelement hat den Vorteil, dass es besonders einfach herstellbar ist. Die geometrische Form des Bondpads kann dabei beispielsweise rund, dreieckig, viereckig, vieleckig sein oder auch beliebige irreguläre Formen annehmen.

Die Kontaktlinien bei einem derartigen Bauelement sind vorteilhafterweise gitterförmig ausgeformt, so dass besonders gleichmäßig der am Bondpad anliegende Strom über die funktionelle Schicht verteilt werden kann. Das Material der zweiten Schicht, aus dem normalerweise der Bondpad strukturiert wird, ist vorteilhafterweise Gold, während das Material der ersten Schicht, aus dem die Kontaktlinien gebildet werden, vorteilhafterweise Platin sein kann. Möglich ist weiterhin ein elektrisches Bauelement umfassend ein Substrat mit einer darauf angeordneten ersten und zweiten Struktur, wobei die erste Struktur einen sich zum Substrat hin verbreiternden Querschnitt und eine geometrische Form aufweist, deren Umfang zusätzliche Einbuchtungen aufweist.

Wie oben besprochen sind diese Einbuchtungen und der sich zum Substrat hin verbreiternde Querschnitt auf das isotrope Ätzen dieser ersten Struktur zurückzuführen.

Im Folgenden werden Beispiele näher erläutert.
Die Figuren 1A bis 1F zeigen schematisch im Querschnitt eine Variante eines Verfahrens.
Die Figuren 2A und 2B zeigen in der Aufsicht vergrößerte Aufnahmen eines Bondpads während des isotropen Strukturierens der zweiten Schicht im Verfahrensschritt C) .
Figur 3 zeigt ein Beispiel eines Bondpads mit Kontaktlinien.
Figur 4 zeigt ein mögliches Beispiel eines erfindungsgemäßen elektrischen Bauelements.

Figur 1A zeigt im Querschnitt eine Anordnung aus einem Substrat 5 zusammen mit einer darauf aufgebrachten ersten Schicht 10 und zweiten Schicht 15 nach Verfahrensschritt A) des erfindungsgemäßen Verfahrens. Wenn beispielsweise elektrische Kontaktierungen in Form von Kontaktlinien und Bondpads für ein elektrisches Bauelement aufgebaut werden sollen, kann beispielsweise die erste Schicht 10 Platin und die zweite Schicht 15 Gold umfassen.

Anschließend wird im Verfahrensschritt B) wie in Figur 1B gezeigt, eine Maskenstruktur 20 auf der zweiten Schicht 15 erzeugt. Diese Maskenstruktur 20 weist dabei einen geometrisch geformten Bereich 20A auf, unterhalb dessen der Bondpad gebildet wird. Weiterhin weist die Maskenstruktur 20 vom Bereich 20A ausgehende linienförmige Strukturen 20B auf, die im Fall der Herstellung von Kontakten zur Strukturierung der späteren Kontaktlinien aus der ersten Schicht 10 dienen. Diese linienförmigen Strukturen der Maskenstruktur 20 können dabei gitterförmig aufgebaut sein.

Figur 1C zeigt, wie im Verfahrensschritt C) durch die Maskenstruktur 20 hindurch die zweite Schicht 15 mittels eine isotropen Strukturierungsverfahrens strukturiert und dabei teilweise die erste Schicht 10 freigelegt wird. In diesem Verfahrensschritt C) entsteht dabei die zweite strukturierte Schicht 15A, die einen Teil des späteren Bondpads bildet. Figur 1C kann dabei entnommen werden, dass es aufgrund des isotropen Strukturierungsverfahrens zu einer Unterätzung der Maskenstruktur 20 kommt, so dass sich die Einbuchtungen 25A in der zweiten strukturierten Schicht 15A bilden. Dies hat zur Folge, dass der Querschnitt 15C der zweiten strukturierten Schicht 15A sich zum Substrat 5 hin verbreitert. Das isotrope Strukturierungsverfahren, beispielsweise isotrope Ätzen, entfernt dabei vorteilhafterweise und wie in Figur 1C gezeigt, große Bereiche der zweiten Schicht 15, die unterhalb der kleineren Strukturen 20B der Maskenstruktur 20 vorhanden sind, so dass weite Bereiche der Maskenstruktur 20 komplett unterhöhlt sind.

In einem nachfolgenden hier in Figur 1D dargestellten Verfahrensschritt C1) werden dabei diejenigen Teile der Maskenstruktur 20, die unterhöhlt wurden, auf die erste Schicht 10 abgesenkt. Dies kann beispielsweise dadurch geschehen, dass die Maskenstruktur 20 getrocknet wird, um die wässrigen Reinigungsmittel zu entfernen, die zum Ausspülen des Ätzmediums, das im Verfahrensschritt C) eingesetzt wurde, verwendet wurden. Das Ätzmedium kann beispielsweise nasschemische Ätzmittel umfassen. Zur Trocknung kann dabei die gesamte Anordnung aus der Maskenstruktur, den beiden Schichten sowie den Substrat in eine Schleudervorrichtung eingebracht werden, wobei besonders vorteilhaft gleichzeitig die unterhöhlten Bereiche der Maskenstruktur 20 auf die erste Schicht 10 abgesenkt werden. Das Absenken der Maskenstruktur 20 auf die erste Schicht 10 ermöglicht ein besonders genaues Übertragen der Struktur der Maskenstruktur im nachfolgenden Verfahrensschritt D) auf die erste Schicht 10.

Anschließend wird im Verfahrensschritt D) durch die Maskenstruktur 20 hindurch die erste Schicht 10 strukturiert, wobei die kleineren Strukturen 20B der Maskenstruktur 20 in die erste Schicht übertragen werden. Dabei wird die erste strukturierte Schicht 10A gebildet (Figur 1E). Dabei wird ein Kontaktgitter gebildet, wie es beispielsweise in den Figuren 2A und 2B in der Aufsicht dargestellt ist.

Anschließend wird im Verfahrensschritt E) die Maskenstruktur 20 entfernt, wobei dann das Bondpad 25 bestehend aus den ersten und zweiten strukturierten Schichten 10A, 15A und zusätzlich die Kontaktlinien 30 freigelegt werden (Figur 1F). Das Bondpad 25 kann beispielsweise zur elektrischen Kontaktierung eines Bauelements dienen, wenn ein Draht angebondet wird.

Die Figuren 2A und 2B zeigen das isotrope Strukturieren der zweiten Schicht, einer Goldschicht durch die Maskenstruktur 20 hindurch. Wie in Figur 2A zu sehen ist, werden dabei die gitterförmigen Bereiche, die linienförmigen Strukturen 20B der Maskenstruktur während des isotropen Ätzvorgangs unterhöhlt, wobei in Figur 2A an den Kreuzungspunkten der linienförmigen Strukturen 20B noch Reste 35 der zweiten Goldschicht vorhanden sind. Hier ist die Unterhöhlung also noch nicht komplett. Weiterhin ist zu erkennen, dass aufgrund der isotropen Strukturierung Einbuchtungen 25A im Bondpad 25 gebildet werden, die ebenfalls auf eine Unterhöhlung der Maskenstruktur zurückzuführen sind. Die ursprüngliche geometrische Form des Bereichs der Maskenstruktur ist in diesem Fall kreisförmig, so dass aufgrund ein kreisförmiger Bondpad mit zusätzlichen Einbuchtungen 25A resultiert. In Figur 2B ist der Verfahrensschritt C) abgeschlossen. Dabei sind keine Bereiche 35 der zweiten Goldschicht unterhalb der Kreuzungspunkte der linienförmigen Strukturen 20B der Maskenstruktur mehr vorhanden.

Figur 3 zeigt in der Aufsicht eine weitere mögliche Ausführungsform eines Bondpads 25 mit Kontaktlinien 30 in Form von zackenförmigen Strahlen. Die ursprüngliche geometrische Form des Bereichs der Maskenstruktur ist hier gestrichelt als Form 20A angedeutet. Die ursprüngliche Form war in diesem Fall viereckig. Daraus resultiert im Verfahrensschritt C) aufgrund der isotropen Strukturierung eine Form 25B, die zusätzlich zum Viereck 20A Einbuchtungen 25A aufweist. Die strahlenförmigen Kontaktlinien 30 stellen dabei eine mögliche Variation der Kontaktlinien dar, die häufig gitterförmig sind.

Figur 4 zeigt eine schematische perspektivische Ansicht eines Bauelements. Das Bauelement ist in diesem Fall eine InGaN-LED. Dabei sind auf einem Substrat 5, beispielsweise einem Saphir-Substrat, verschiedene funktionelle Schichten aufgebracht. Dabei handelt es sich beispielsweise um eine GaN-Pufferschicht 45, n-dotiertes Galliumnitrid 40, ein InGaN-Multiquantenwell 50 sowie P-Galliumnitrid 36. Weiterhin sind noch zusätzliche mit verschiedenen Elementen, beispielsweise Aluminium oder Indium dotierte Galliumnitridschichten vorhanden, die hier nicht einzeln bezeichnet sind. Auf der p-dotierten Galliumnitridschicht, die häufig schlecht elektrisch leitend ist, sind Kontakte aufgebracht, die z.B. mittels des hier beschriebenen Verfahrens hergestellt werden können. Nämlich das Bondpad 25 mit den z. B. aufgrund des Verfahrens zusätzlich vorhandenen Einbuchtungen 25A sowie ein Kontaktgitter 30 zur besseren Übertragung des elektrischen Stroms auf die p-dotierte Galliumnitridschicht 36. Weiterhin ist noch eine n-Elektrode 60 auf der n-dotierten Galliumnitridschicht vorhanden. Die Kontakte können dabei ebenfalls auf der n-dotierten Galliumnitridschicht aufgebracht werden.

### Beispiel

Im Verfahrensschritt A) des Verfahrens wird dabei eine InGaN-LED mit einer ersten Schicht aus Platin mit einer Dicke von 40 nm und anschließend mit einer zweiten Schicht aus Gold mit einer Dicke von 1.000 nm bedampft. Anschließend wird der Fotolack AZ 1505 (Clariant) aufgeschleudert und 2 Sekunden mit einer entsprechenden Maske (Stegbreite 2,5 *µ*m und mit einem zentrischen Bondpad mit einem Durchmesser von 120 *µ*m) belichtet. Danach werden die belichteten Bereiche mit dem Entwickler AZ 351B entwickelt, wobei die Maskenstruktur gebildet wird. Diese wird danach 30 Minuten bei 120° C getrocknet. Im Verfahrensschritt C) wird dann die zweite Schicht, die Goldschicht, mit einem wässrigen cyanidhaltigen Ätzmedium für Gold geätzt, wobei noch 1 1/2 Minuten nachgeätzt wird, um eine gute Unterhöhlung der Maskenstruktur zu erreichen. Anschließend wird das Ätzmedium durch Spülen des Substrats mit Wasser entfernt und danach im Spin-Rinser-Dryer bei maximal 2.400 U/min. getrocknet, wobei zusätzlich die unterhöhlten Bereiche der Maskenstruktur auf die erste Schicht, die Platinschicht, abgesenkt werden. Dabei wird anschließend bei niedriger Umdrehung im Spin-Rinser-Dryer unter Stickstoff-Fluss nachgetrocknet. Danach wird die Platinschicht 6 Minuten im Argonplasma mittels Sputtern geätzt (Verfahrensschritt D)). Danach wird die Maskenstruktur im Posistrip entfernt.

Weitere Variationen sind beispielsweise möglich hinsichtlich der Geometrie des Bondpads, sowie hinsichtlich Form und Funktion der Kontaktlinien.

## Patentansprüche

1. Verfahren zur Erzeugung einer strukturierten Schicht (10A) mit den Verfahrensschritten:
A) auf einem Substrat (5) wird eine erste Schicht (10) und darüber zumindest eine zweite Schicht (15) angeordnet,
B) auf der zweiten Schicht (15) wird eine Maskenstruktur (20) mit einer ersten (20A) und zweiten Struktur (20B) erzeugt, wobei die erste (20A) und die zweite Struktur (20B) nebeneinander angeordnet sind, wobei die erste Struktur (20A) der Maskenstruktur (20) eine Grobstruktur und die zweite Struktur (20B) der Maskenstruktur (20) eine Feinstruktur ist, und wobei die Ausdehnungen der Grobstruktur größer sind als die Ausdehnungen der Feinstruktur,
C) die zweite Schicht (15) wird durch ein isotropes Verfahren strukturiert, wobei die Maskenstruktur (20) im Bereich der zweiten Struktur (20B) unterätzt wird wodurch teilweise die erste Schicht (10) freigelegt wird,
D) anschließend werden die freigelegten Bereiche der ersten Schicht (10) durch ein anisotropes Verfahren strukturiert.

2. Verfahren nach dem vorhergehenden Anspruch,
wobei die kleinste Ausdehnung der Grobstruktur mindestens doppelt so groß ist wie kleinste Ausdehnung der Feinstruktur.

3. Verfahren nach den vorhergehenden Ansprüchen,
- bei dem im Verfahrensschritt C) durch das isotrope Verfahren die Grobstruktur der Maske in die zweite Schicht übertragen wird
- bei dem im Verfahrenschritt D) durch das anisotrope Verfahren die Feinstruktur der Maske in die erste Schicht übertragen wird.

4. Verfahren nach einem der vorhergehenden Ansprüche,
bei dem im Verfahrenschritt C) ein für die zweite Schicht selektives Ätzmittel verwendet wird.

5. Verfahren nach einem der vorhergehenden Ansprüche,
bei dem im Verfahrensschritt A) Metallschichten als erste und/oder zweite Schicht erzeugt werden.

6. Verfahren nach dem vorhergehenden Anspruch,
wobei im Verfahrensschritt A) als erste Schicht eine Pt-Schicht und als zweite Schicht eine Au-Schicht auf dem Substrat erzeugt werden.

7. Verfahren nach einem der vorhergehenden Ansprüche,
wobei im Verfahrensschritt B) eine Photolackschicht erzeugt und mittels Photolithographie zur Maskenstruktur strukturiert wird.

8. Verfahren nach einem der vorhergehenden Ansprüche,
bei dem in einem an den Verfahrenschritt C) anschließenden Verfahrensschritt C1) die Maskenstruktur in Bereichen in denen die zweite Schicht unterhalb der Maskenstruktur entfernt wurde, auf die erste Schicht abgesenkt wird.

9. Verfahren nach einem der vorhergehenden Ansprüche,
- bei dem im Verfahrensschritt C) die zweite Schicht mittels naßchemischen isotropen Ätzens strukturiert wird,
- wobei im Verfahrensschritt D) die erste Schicht mittels anisotroper Trockenätzverfahren strukturiert wird.

10. Verfahren nach einem der vorhergehenden Ansprüche,
bei dem im Verfahrensschritt C) die zweite Schicht bis auf einen oder mehrere Bereiche unterhalb der Maskenstruktur entfernt wird.

11. Verfahren nach einem der vorhergehenden Ansprüche, wobei in einem an D) anschließenden Verfahrensschritt E) die Maskenstruktur (20) entfernt wird.

12. Verfahren nach einem der vorhergehenden Ansprüche, zur Herstellung eines elektrischen Bauelements (1), wobei
- Im Verfahrensschritt A) das Substrat (5) mit zusätzlichen funktionellen Schichten (36, 40, 45, 50) unter der ersten Schicht (10) bereitgestellt wird, wobei erste und zweite Schicht (10,15) jeweils als Metallschicht ausgebildet werden,
- im Verfahrensschritt B) eine Maskenstruktur (20) mit zumindest einem geometrisch geformten Bereich (20A) als erste Struktur und davon ausgehenden linienförmigen Strukturen (20B) als zweite Struktur erzeugt wird,
- im Verfahrensschritt C) die zweite Schicht (15) zu einem unterhalb des zumindest einem geometrisch geformten Bereichs (20A) der Maskenstruktur (20) angeordneten Bereich (15A) strukturiert wird, wobei ein Bondpad (25) gebildet wird,
- im Verfahrensschritt D) die linienförmigen Strukturen (20B) der Maskenstruktur (20) in die erste Schicht (10) übertragen werden, wobei Kontaktlinien (30) gebildet werden,
- wobei das Bondpad (25) eine im wesentlichen der geometrischen Form (20A) des geometrisch geformten Bereichs der Maskenstruktur entsprechende Form (25B) und einen sich zum Substrat hin verbreiternden Querschnitt (25C) aufweist.

13. Verfahren nach dem vorhergehenden Anspruch,
bei dem die linienförmigen Strukturen (20B) der Maskenstruktur (20) gitterförmig ausgeformt werden.

14. Verfahren nach einem der vorhergehenden Ansprüche,
bei dem im Verfahrensschritt C) nur die erste Struktur der Maskenstruktur in die zweite Schicht und im Verfahrensschritt D) nur die zweite Struktur der Maskenstruktur in die erste Schicht übertragen werden.

15. Elektrisches Bauelement (1),
- umfassend ein Substrat (5) mit darauf aufgebrachten funktionellen Schichten umfassend eine GaN-Pufferschicht, n-dotiertes Galliumnitrid, InGaN-Multiquantenwell, p-Galliumnitrid und mit Aluminium oder Indium dotierte Galliumnitridschichten, und einer auf den funktionellen Schichten angeordneten ersten (15A) und zweiten Struktur (10A),
- wobei die erste Struktur (15A) ein Bondpad mit einem sich zum Substrat (5) hin verbreiternden Querschnitt (15C) und als Material Gold aufweist,
- wobei die erste Struktur eine Grobstruktur und die zweite Struktur eine Feinstruktur ist,
- wobei die kleinste Ausdehnung der Grobstruktur mindestens doppelt so groß ist wie kleinste Ausdehnung der Feinstruktur, und
- wobei die zweite Struktur (10A) gitterartig ausgeformte Kontaktelinien aufweist, die als Material Platin aufweisen so dass ein am Bondpad anliegender Strom über die funktionellen Schichten verteilt werden kann.

## Claims

1. A method for producing a structured layer (10A), comprising the method steps of:
A) a first layer (10) and at least one second layer (15) on top of it is arranged on a substrate (5)
B) producing a mask structure (20) having a first (20A) and a second structure (20B) on the second layer (15), wherein the first (20A) and the second structure (20B) are arranged next to one another, wherein the first structure (20A) of the mask structure (20) is a rough structure and the second structure (20B) of the mask structure (20) is a fine structure, and wherein the rough structure has an expansion which is larger than the expansion of the fine structure,
C) the second layer (15) is structured by means of an isotropic process, wherein the mask structure (20) is underetched in the region of the second structure (20B), whereby the first layer (10) is partially exposed,
D) subsequently, structuring of the exposed regions of the first layer (10) by means of an anisotropic process.

2. The method according to the preceding claim,
wherein the smallest expansion of the rough structure is at least twice as large as the smallest expansion of the fine structure.

3. The method according to the preceding claims,
- in which in method step C), the rough structure of the mask is transferred into the second layer,
- in which in method step D), by means of the anisotropic process, the fine structure of the mask is transferred into the first layer.

4. The method according to one of the preceding Claims,
in which in method step C) an etching agent selective for the second layer is used.

5. The method according to one of the preceding claims,
in which metal layers are produced as first and/or second layer in method step A).

6. The method according to the preceding claim,
wherein in method step A), a Pt-layer is generated as a first layer and an Au-layer is generated as a second layer on the substrate.

7. The method according to one of the preceding claims,
wherein in method step B), a photoresist layer is produced and structured into the mask structure by means of photolithography.

8. The method according to one of the preceding claims,
in which in a method step C1) subsequent to method step C), the mask structure is lowered on to the first layer in regions in which the second layer below the mask structure was removed.

9. The method according to one of the preceding claims,
- in which in method step C), the second layer is structured by means of wet-chemical isotropic etching,
- wherein in method step D), the first layer is structured by means of anisotropic dry etching processes.

10. The method according to one of the preceding claims,
in which in method step C), the second layer is removed, except for one or multiple regions below the mask structure.

11. The method according to one of the preceding claims,
in which in a method step E) subsequent to method step D), the mask structure (20) is removed.

12. The method according to one of the preceding claims, for producing an electric component (1), wherein
- in method step A), the substrate (5) is provided with additional functional layers (36, 40, 45, 50) below the first layer (10), wherein first and second layers (10, 15) are formed as a metal layer, respectively,
- in method step B), a mask structure (20) is produced, having at least one geometrically-shaped region (20A) as a first structure and line-type structures (20B) originating therefrom as a second structure,
- in method step C), the second layer (15) is structured into a region (15A) arranged below the at least one geometrically-shaped region (20A) of the mask structure (20), wherein a bondpad (25) is formed,
- in method step D), the line-type structures (20B) of the mask structure (20) are transferred into the first layer (10), wherein contact lines (30) are formed,
- wherein the bondpad (25) has a shape (25B) substantially corresponding to the geometrical shape (20A) of the geometrically-shaped region of the mask structure and has a cross-section (25C) enlarging towards the substrate.

13. The method according to the preceding claim,
in which the line-type structures (20B) of the mask structure (20) are formed in the form of a grid.

14. The method according to one of the preceding claims,
in which in method step C), only the first structure of the mask structure is transferred into the second layer, and in method step D), only the second structure of the mask structure is transferred into the first layer.

15. Electric component (1),
- including a substrate (5) having functional layers applied thereon, including a GaN buffer layer, n-doped gallium nitride, InGaN multi-quantum-well, p-gallium nitride and gallium nitride layers doped with aluminum or indium, and a first (15A) and second structure (10A) arranged on the functional layers,
- wherein the first structure (15A) comprises a bondpad having a cross-section (15C) enlarging towards the substrate (5) and comprises gold as a material,
- wherein the first structure is a rough structure and the second structure is a fine structure,
- wherein the smallest expansion of the rough structure is at least twice as large as the smallest expansion of the fine structure, and
- wherein the second structure (10A) comprises contact lines formed in the type of a grid, which comprise platinum as a material, such that a current applied to the bondpad can be distributed over the functional layers.

## Revendications

1. Procédé destiné à générer une couche structurée (10A), comprenant les étapes de procédé :
A) sur un substrat (5) sont disposées une première couche (10) et, par-dessus, au moins une deuxième couche (15),
B) sur la deuxième couche (15) est générée une structure de masque (20) comprenant une première structure (20A) et une deuxième structure (20B), la première structure (20A) et la deuxième structure (20B) étant disposées l'une à côté de l'autre, la première structure (20A) de la structure de masque (20) étant une structure grossière et la deuxième structure (20B) de la structure de masque (20) étant une structure fine, et les expansions de la structure grossière étant plus grandes que les expansions de la structure fine,
C) la deuxième couche (15) étant structurée au moyen d'un procédé isotrope, la structure de masque (20) étant sous-rongée dans la partie de la deuxième structure (20B), sur quoi la première couche (10) est partiellement exposée,
D) les parties exposées de la première couche (10) étant ensuite structurées au moyen d'un procédé anisotrope.

2. Procédé selon la revendication précédente,
la plus petite expansion de structure grossière étant au moins le double de la plus petite expansion de la structure fine.

3. Procédé selon les revendications précédentes,
- dans lequel, à l'étape de procédé C), la structure grossière du masque, en raison du procédé isotrope, est transmise dans la deuxième couche,
- dans lequel, à l'étape de procédé D), la structure fine du masque, par le procédé anisotrope, est transmise dans la première couche.

4. Procédé selon l'une quelconque des revendications précédentes,
dans lequel, à l'étape de procédé C), un corrosif sélectif pour la deuxième couche est utilisé.

5. Procédé selon l'une quelconque des revendications précédentes,
dans lequel, à l'étape de procédé A), des couches métalliques sont générées comme première et/ou deuxième couches.

6. Procédé selon la revendication précédente,
dans lequel, à l'étape de procédé A), sont générées sur le substrat une couche Pt comme première couche et une couche Au comme deuxième couche.

7. Procédé selon l'une quelconque des revendications précédentes,
dans lequel, à l'étape de procédé B), une couche de laque photosensible est générée et structurée par photolithographie pour devenir la structure de masque.

8. Procédé selon l'une quelconque des revendications précédentes,
dans lequel, dans une étape de procédé C1) succédant à l'étape de procédé C), la structure de masque, dans les parties dans lesquelles la deuxième couche a été enlevée en dessous de la structure de masque, est abaissée à la première couche.

9. Procédé selon l'une quelconque des revendications précédentes,
- dans lequel, à l'étape de procédé C), la deuxième couche est structurée par gravure isotrope par chimie humide,
- dans lequel, à l'étape de procédé D), la première couche est structurée par procédé de gravure sèche anisotrope.

10. Procédé selon l'une quelconque des revendications précédentes,
dans lequel, à l'étape de procédé C), la deuxième couche est enlevée jusqu'à une ou plusieurs parties en dessous de la structure de masque.

11. Procédé selon l'une quelconque des revendications précédentes,
dans lequel, dans une étape de procédé E) succédant à l'étape de procédé D), la structure de masque (20) est enlevée.

12. Procédé selon l'une quelconque des revendications précédentes, destiné à la fabrication d'un composant électrique (1), dans lequel
- à l'étape de procédé A), le substrat (5) est fourni avec des couches fonctionnelles supplémentaires (36, 40, 45, 50) en dessous de la première couche (10), la première et la deuxième couches (10, 15) étant respectivement réalisées comme couche métallique,
- à l'étape de procédé B), une structure de masque (20) comprenant au moins une partie (20A) formée de manière géométrique est générée comme première structure et des structures (20B), en forme de lignes qui en partent, sont générées comme seconde structure,
- à l'étape de procédé C), la deuxième couche (15) est structurée en une zone (15A) disposée en dessous de l'au moins une partie (20A) de la structure de masque (20) formée de manière géométrique, un plot de connexion (25) étant formé,
- à l'étape de procédé D), les structures (20B) en forme de lignes de la structure de masque (20) sont transmises dans la première couche (10), des lignes de contact (30) étant formées,
- le plot de connexion (25) présentant une forme (25B) correspondant essentiellement à la forme géométrique (20A) de la partie de la structure de masque formée de manière géométrique et présentant une section transversale (25C) s'élargissant en direction du substrat.

13. Procédé selon la revendication précédente,
dans lequel les structures (20B) en forme de lignes, de la structure de masque (20) sont formées en forme de grille.

14. Procédé selon l'une quelconque des revendications précédentes,
dans lequel, à l'étape de procédé C), seulement la première structure de la structure de masque est transmise dans la deuxième couche et, dans lequel, à l'étape D), seulement la deuxième structure de la structure de masque est transmise dans la première couche.

15. Composant électrique (1)
- comprenant un substrat (5) doté de couches fonctionnelles qui sont placées dessus, comprenant une couche tampon GaN, du nitrure de gallium dopé n, une onde quantique multiple InGaN, du nitrure de gallium p et des couches de nitrure de gallium dopées avec de l'aluminium ou de l'indium, et comprenant une première structure (15A) et une deuxième structure (10A) disposées sur les couches fonctionnelles,
- la première structure (15A) présentant un plot de connexion ayant une section transversale (15C) s'élargissant en direction du substrat (5) et de l'or comme matière,
- la première structure étant une structure grossière et la deuxième structure étant une structure fine,
- la plus petite expansion de la structure grossière étant au moins le double de la plus petite expansion de la structure fine, et
- la deuxième structure (10A) présentant des lignes de contact formées en forme de grille, lesquelles présentent du platine comme matière, de sorte qu'un courant appliquée sur le plot de connexion peut être réparti par les couches fonctionnelles.
